# EUROPEAN PATENT SPECIFICATION

(11) **EP 2 696 206 B1**
(45) Date of publication and mention of the grant of the patent: **01.11.2023**
(21) Application number: 12005696.5
(22) Date of filing: 06.08.2012
(51) Int. Cl.: G01R 15/04, G01R 1/18, H02G 5/06

(54) **Medium or high voltage arrangement with cable connection terminal**
Mittel- oder Hochspannungsanordnung mit Kabelverbindungsendgerät
Agencement de moyenne ou haute tension présentant une borne de connexion de câble

(43) Date of publication of application: 12.02.2014
(73) Proprietor: ABB Schweiz AG, 5400 Baden (CH)
(72) Inventor: Podzemny, Jaromir, 621 00 Brno (CZ); Javora, Radek, 624 62 Hrusovany u Brna (CZ)
(74) Representative: Maiwald GmbH

(56) References cited:
- EP-A1- 0 678 956
- EP-A1- 1 821 320
- EP-A1- 2 463 867
- EP-A2- 0 510 427
- EP-A2- 1 391 740
- CN-Y- 2 689 243
- DE-A1- 1 516 244
- DE-A1- 10 344 165
- DE-A1- 19 508 582
- DE-A1- 19 841 164
- DE-A1- 19 855 528
- ES-A1- 2 302 413
- FR-A1- 2 506 947
- US-A- 2 944 198
- US-A- 5 408 236
- US-A1- 2010 253 366

## Description

The invention relates to a medium or high voltage arrangement with cable connection terminal and voltage sensor, wherein the voltage sensor has a resistive voltage divider and shielding electrodes.

Known are devices which use resistive and/or capacitive dividers for voltage measurement and/or for protection purposes. Such devices, which operates at medium or at high voltage levels, may be exposed to a strong electric field which, being placed at very close vicinity, may influence measured quantities mainly in case of low-power outputs or introduce high dielectric stress on insulating material or on surface of such an equipment. Further influences could be observed, in case of outdoor installations, during raining or humid conditions, which may change electric field distribution thus causing error to measured voltage level or causing corona on the surface of devices or increased partial discharge level within devices.

DE 10344165A1 describes that an electrical functional unit (EFU) has a high-voltage connection and an earth connection. Field control elements (FCE) fit around the EFU and influence the electrical field around the EFU, which is cast in insulating material along with the FCE. All these produce an electrical field that is as homogenous as possible and that can be produced with particular benefit. An independent claim is also included for a method for producing an insulating system for medium high voltage installations.

DE 19508582A1 describes a voltage transformer with a voltage divider for measuring the voltage in medium and high voltage installations has ohmic divider resistance combined with means for compensating electromagnetic influences from the environment. The divider resistance is made in a single piece with a measurement resistance and is provided with taps. The divider resistance consists of a metallic material vaporised on a substrate or is manufactured by thick film technology. At least one tap is connected to at least one, in particular capacitive, compensation means.

FR 2506947A1 describes a device for measuring high alternating voltages in high-voltage switching installations, particularly in metal-encapsulated SF6-gas-insulated high-voltage switching installations, has at least two ohmic resistors arranged in series between the high-voltage potential and earth and forming an ohmic voltage divider, of which the resistor connected to earth is used as measuring resistor. The resistor at the high-voltage end and the measuring resistor are formed of in each case at least one resistance element which consists of an insulating body and resistance material applied thereto. To reduce the constructional size and to simplify the structure, the insulating body is constructed to be tubular and covered on its outside with the resistance material, which is a thick-film paste applied to the insulating body in the form of resistance tracks. The transient voltage distribution is controlled by a single, cap-shaped control electrode.

EP 0678956A1 describes that a combined current and voltage sensor for a high voltage switchgear panel has a housing made from age-hardening castable material. At one end, the housing has a cavity, in the bottom of which is a contact element. The cavity has a lid made from insulating material. Between the lid and the contact element is an elongated high ohmage resistor, used as a voltage sensor. The contact element is connected to a conductor embedded in the housing and at the other end of the conductor is a circuit breaker. A Rogowski coil around this conductor acts as the current sensor.

EP 0510427A2 describes that the voltage transformer which can be used in a medium- or high-voltage system exhibits an ohmic voltage divider, which is of rotationally symmetric shape, as voltage sensor. This voltage sensor can be brought into contact with a voltage-conducting part and with a part which is at earth potential of the system. The voltage transformer is intended to be distinguished by high measuring accuracy even under the most varied operating conditions of the system containing it. This is achieved by the fact that the voltage sensor constructed as voltage divider, after being installed in the system, is arranged in a space which is largely shielded against electrical fields.

A voltage divider consists of an insulating body, which is housing high voltage impedance being connected to high voltage at one end and to low voltage impedance at the other end. Low-voltage impedance needs to be connected to the ground. Output of such impedance divider is done by means of two wires and or cable.

Disadvantage of such simple measurement means is higher susceptibility to parasitic capacitances and thus possibility to change accuracy of measured voltage providing inaccurate values for protection and/or measurement purposes.

Majority of known voltage sensors are using special shielding electrodes which are always designed for a particular application and for a voltage sensing size and principle used. A general impedance divider has insulating body accommodating impedance which is connected at one end to high voltage and at the other end to low-voltage impedance. Both high-voltage impedance and low-voltage impedance form a voltage divider with given division ratio. Voltage divider is grounded through ground connection. Output wires go through the cable which is shielded in order to minimize effects of external field on low-voltage signal going through the output wires. In order to reduce capacitive pick-up from external voltage sources or fields, shielding electrodes are used around divider.

Apart from external influences, shielding electrodes improve electric field distribution on surface of the insulating body or within that insulating body, thus enables higher dielectric withstand of the device.

The use of shielding electrodes minimizes sensitivity of the voltage divider towards external connections to high-voltage or to other surrounding devices connected to high potential.

It is an object of the invention, to enhance the accuracy of voltage measurement at medium and/or high voltage equipment.

In the claimed invention, there is provided a medium or high voltage arrangement as defined in appended claim 1. Preferred embodiments are provided in appended dependent claims 2 to 4.

This problem is solved by the invention, in that way, that the voltage sensor is applied as a voltage sensor module, which is integrated in a further cable connection terminal, and that the shielding electrodes are integral part of the voltage sensor module or integral part of an insulating housing part of the terminal. By that, the voltage measurement can take place with higher accuracy.

In the invention it is said, that the shielding electrodes are applied at the low voltage and high voltage side of a resistive voltage divider with different conical shape in that way, that the opening diameter of the shielding electrode at the low voltage side is greater than the opening diameter of the shielding electrode at the high voltage side.

An advantageous special embodiment is, that the further cable connection terminal housing has an opening with a conical shape at least at the inner surface in that way, that the cone diameter increases from inside towards outside, and that at least the inner surface of the cone is covered with a conductive or semiconductive layer, and that the resistive voltage sensor divider is located in that way, that the high-voltage side is placed at the side with smaller inner diameter of the terminal opening, and in an unclaimed embodiment useful for understanding the invention, the high voltage side is placed at the bigger diameter of the terminal housing opening. By this alternative embodiment it is possible to make separate shielding elements obsolete, if the inner surface of the terminal opening is covered with a conductive layer as a kind of integral shielding electrode. Such electrode layer can also be located inside of the terminal housing or on its outer perimeter.

In a further advantageous embodiment the further cable connection terminal is applied adjacently to the cable terminal of the operating cable connection of the switchgear or other high or medium voltage arrangement, at the outgoing section side of for example a the pole part.

A further advantageous embodiment is, that the voltage sensor module is electrically connected to the further cable connection terminal.

A further advantageous embodiment is, that the voltage sensor is applied as a voltage sensor module, which is integrated in the a further cable connection terminal, and that the shielding electrodes are integral part of the voltage sensor module or integral part of an insulating housing part of the terminal, that instead of a resistive voltage divider only low- and high-voltage electrodes are applied for voltage sensing purpose.

A further advantageous embodiment is, that the high-voltage shielding electrode and the low voltage shielding electrode are arranged in relation to each other in such, that they at least partly overlap. This gives further enhancement of accuracy in voltage measurement.

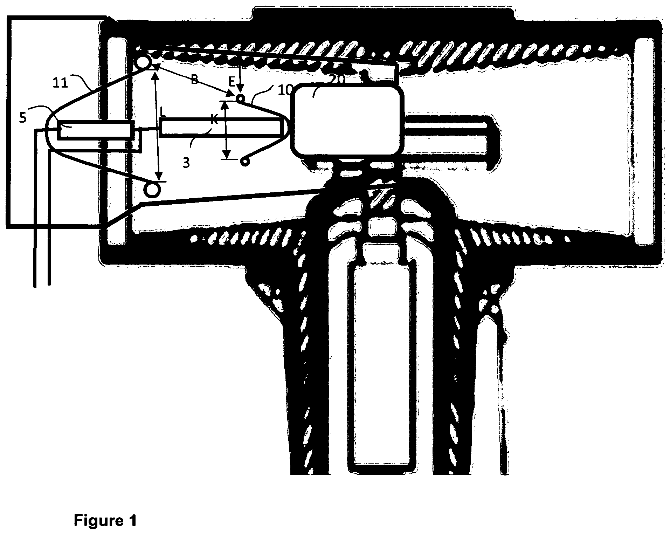

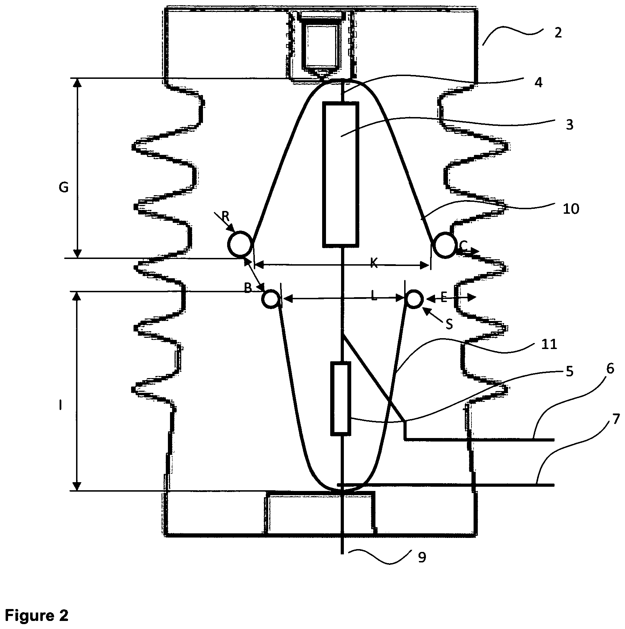

An advantageous embodiment of the invention is shown in figure 1 and an unclaimed example useful for understanding the invention is shown in figure 2.

In figure 2, the proposed example suggest the use of shielding electrodes where upper shielding electrode 10 has a conical shape which increases distance from resistive divider 3 along his axis. This is in line with decrease of electric potential inside of the resistive divider. Due to such electrode 10 design, constant electric stress of insulating material between electrode 10 and resistor 3 is achieved. Lower shielding electrode 11 is also having conical shape, but is located in opposite direction from the upper electrode 10.

Best dielectric and most accurate results for stand-alone post insulator shape of voltage divider body 2 is achieved when lower shielding electrode 11 has the same or lower maximum diameter L comparing to maximum diameter K of the upper electrode 10. In this case, design is optimized in the way to shield as much as possible by high voltage electrode 10 in order to minimize effect of parasitic capacitances coming from connection to high voltage system.

In case the application of resistive divider is not as stand-alone device but integrated into other parts of the system, e.g. cable terminal, it is better to have lower shielding electrode 11, connected to the ground potential, bigger then the upper electrode 10 connected to the high voltage potential. Such configuration is shown in Fig. 1, with high-voltage terminal 20.

Minimum phase error could be achieved by putting the smaller electrode at least partly inside of the bigger one, with keeping sufficient distance B in between them.

A further embodiment could be, that no resistive voltage divider is used. But the voltage measuring means consist of shielding electrodes without resistive voltage divider, so that the voltage measuring means only is based on the shielding electrodes thus forming a kind of capacitive divider.

Furthermore the shielding electrodes in both cases, capacitive measurement and resistive measurement can be obsolete, as separate shielding elements, if the inner surface of the terminal opening of the insulating body will be covered in the inner surface with a conductive material.

A further advantageous embodiment is, that the voltage sensor is applied as a voltage sensor module, which is integrated in the further cable connection terminal, and that the shielding electrodes are integral part of the voltage sensor module or integral part of an insulating housing part of the terminal, and the shielding electrodes are used for voltage indication of for voltage detection purposes, whereas voltage sensor module is used for voltage measurement purposes.

Further embodiment is, that the high-voltage shielding electrode and the low voltage shielding electrode are arranged in relation to each other in such, that they, from external point of view at least partly overlap.

In a further unclaimed refinement is given, that in the use of a high voltage electrode the shape of the opening is non conical but oval or parabolic.

A further refinement is, that the end of each electrode is rounded with minimum radius of 0,1 mm.

Furthermore the electrode is made at least partly out of conductive material, capable of distributing electric potential.

A last important refinement is, that the minimum phase error is achieved when division ration of capacitive resistances, created by shielding electrodes, match division ratio of the resistors R1 and R2 of the resistive divider.

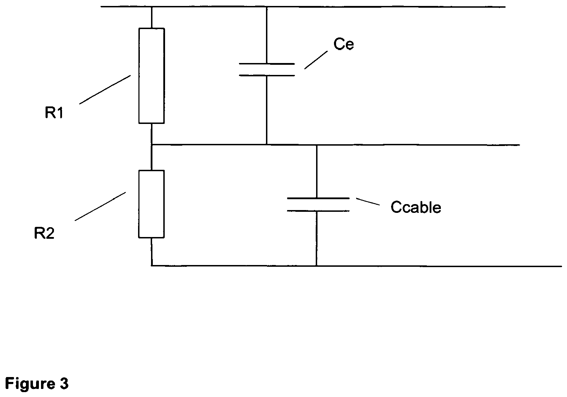

Fig. 3 describes the effect of shielding electrode on electrical parameters and output signal of impedance divider. The resistors R1 and R2, in case of resistive divider, are selected in a way to get required division (transformation) ratio. Any capacitance introduced to the circuit cause phase error (displacement) of the output signal comparing to the measured (input) signal. Ce capacitance is mainly affected by shape and position of the shielding electrodes (if used). Ccable capacitance is mainly caused by cable 8 capacitance. In case the division ratio of reactances caused by capacitances Ce and Ccable match division ratio of the resistors R1 and R2, minimum phase error is achieved.

## Claims

1. A medium or high voltage arrangement, comprising:
- a cable connection terminal;
- a voltage sensor;
- a high voltage terminal (20); and
- a ground potential terminal;
wherein, the voltage sensor is integrated into the cable connection terminal;
wherein, the voltage sensor comprises a resistive voltage divider (3, 5), a low voltage shielding electrode (11), and a high voltage shielding electrode (10), wherein the high voltage electrode comprises a conductive material and the low voltage electrode comprises a conductive material;
wherein, the resistive voltage divider comprises a first resistor (3) and a second resistor (5), wherein the first resistor comprises a first end and a second end opposite to the first end and the second resistor comprises a first end and a second end opposite to the first end;
wherein, the second end of the first resistor is electrically connected to the first end of the second resistor and the first resistor and second resistor are arranged along an axis of the resistive voltage divider;
wherein, the first end of the first resistor is electrically connected to the high voltage terminal;
wherein, the second end of the second resistor is electrically connected to the ground potential terminal;
wherein, the high voltage electrode has a conical shape, wherein the high voltage electrode is directly electrically connected to the high voltage terminal, and wherein only part of the first resistor is located within the conical shape of the high voltage electrode;
wherein, the opening of the conical shape of the high voltage electrode faces away from the high voltage terminal, and wherein the conical shape of the high voltage electrode has a maximum diameter at the opening that has a circular cross-section;
wherein a central axis that extends through the centre of the opening of the conical shape of the high voltage electrode is co-axial with the axis of the resistive voltage divider;
wherein, the low voltage electrode has a conical shape, wherein the low voltage electrode is directly electrically connected to the ground potential terminal, and wherein the second resistor is located within the conical shape of the low voltage electrode;
wherein, the opening of the conical shape of the low voltage electrode faces away from the ground potential terminal, and wherein the conical shape of the low voltage electrode has a maximum diameter at the opening that has a circular cross-section;
wherein a central axis that extends through the centre of the opening of the conical shape of the low voltage electrode is co-axial with the axis of the resistive voltage divider;
wherein, the high voltage electrode is spaced from the low voltage electrode; and
wherein, the maximum diameter of the opening of the conical shape of the high voltage electrode is smaller than the maximum diameter of the opening of the conical shape of the low voltage electrode.

2. Medium or high voltage arrangement according to claim 1, wherein a part of the high voltage electrode is located inside the low voltage electrode.

3. Medium or high voltage arrangement according to any of claims 1-2, wherein the end of the high voltage electrode at the opening and the end of the low voltage electrode at the opening is rounded with a minimum radius of 0,1 mm.

4. Medium or high voltage arrangement according to any of claims 1-3, wherein a ratio of capacitive reactance of the high voltage electrode to the low voltage electrode is equal to a ratio of the resistance of the first resistor to the second resistor.

## Patentansprüche

1. Mittel- oder Hochspannungsanlage, Folgendes umfassend:
- eine Kabelanschlussklemme;
- einen Spannungssensor;
- eine Hochspannungsklemme (20); und
- eine Erdpotentialklemme;
wobei der Spannungssensor in die Kabelanschlussklemme integriert ist;
wobei der Spannungssensor einen Widerstandsspannungsteiler (3, 5), eine Niederspannungs-Abschirmelektrode (11) und eine Hochspannungs-Abschirmelektrode (10) umfasst, wobei die Hochspannungselektrode aus einem leitenden Material und die Niederspannungselektrode aus einem leitenden Material besteht;
wobei der Widerstandsspannungsteiler einen ersten Widerstand (3) und einen zweiten Widerstand (5) umfasst, wobei der erste Widerstand ein erstes Ende und ein dem ersten Ende gegenüberliegendes zweites Ende aufweist, und der zweite Widerstand ein erstes Ende und ein dem ersten Ende gegenüberliegendes zweites Ende aufweist;
wobei das zweite Ende des ersten Widerstands elektrisch mit dem ersten Ende des zweiten Widerstands verbunden ist, und der erste Widerstand und der zweite Widerstand entlang einer Achse des Widerstandsspannungsteilers angeordnet sind;
wobei das erste Ende des ersten Widerstands elektrisch mit der Hochspannungsklemme verbunden ist;
wobei das zweite Ende des zweiten Widerstands elektrisch mit der Erdpotentialklemme verbunden ist;
wobei die Hochspannungselektrode eine konische Form hat, wobei die Hochspannungselektrode direkt elektrisch mit der Hochspannungsklemme verbunden ist, und wobei sich nur ein Teil des ersten Widerstands innerhalb der konischen Form der Hochspannungselektrode befindet;
wobei die Öffnung der konischen Form der Hochspannungselektrode von der Hochspannungsklemme weg weist, und wobei die konische Form der Hochspannungselektrode einen maximalen Durchmesser an der Öffnung hat, die einen kreisförmigen Querschnitt aufweist;
wobei eine zentrale Achse, die sich durch die Mitte der Öffnung der konischen Form der Hochspannungselektrode erstreckt, koaxial mit der Achse des Widerstandsspannungsteilers ist;
wobei die Niederspannungselektrode eine konische Form hat, wobei die Niederspannungselektrode direkt elektrisch mit der Erdpotentialklemme verbunden ist, und wobei sich der zweite Widerstand innerhalb der konischen Form der Niederspannungselektrode befindet;
wobei die Öffnung der konischen Form der Niederspannungselektrode von der Erdpotentialklemme weg weist, und wobei die konische Form der Niederspannungselektrode einen maximalen Durchmesser an der Öffnung hat, die einen kreisförmigen Querschnitt aufweist;
wobei eine zentrale Achse, die sich durch die Mitte der Öffnung der konischen Form der Niederspannungselektrode erstreckt, koaxial mit der Achse des Widerstandsspannungsteilers ist;
wobei die Hochspannungselektrode von der Niederspannungselektrode beabstandet ist; und
wobei der maximale Durchmesser der Öffnung der konischen Form der Hochspannungselektrode kleiner ist als der maximale Durchmesser der Öffnung der konischen Form der Niederspannungselektrode.

2. Mittel- oder Hochspannungsanlage nach Anspruch 1, wobei sich ein Teil der Hochspannungselektrode innerhalb der Niederspannungselektrode befindet.

3. Mittel- oder Hochspannungsanlage nach einem der Ansprüche 1 bis 2, wobei das Ende der Hochspannungselektrode an der Öffnung und das Ende der Niederspannungselektrode an der Öffnung mit einem Mindestradius von 0,1 mm abgerundet ist.

4. Mittel- oder Hochspannungsanlage nach einem der Ansprüche 1-3, wobei das Verhältnis der kapazitiven Reaktanz der Hochspannungselektrode zu der Niederspannungselektrode gleich dem Verhältnis des Widerstands des ersten Widerstands zu dem zweiten Widerstand ist.

## Revendications

1. Agencement de moyenne ou haute tension, comprenant :
- une borne de connexion de câble ;
- un capteur de tension ;
- une borne haute tension (20) ; et
- une borne de potentiel de masse ;
dans lequel le capteur de tension est intégré à l'intérieur de la borne de connexion de câble ;
dans lequel le capteur de tension comprend un diviseur de tension résistif (3, 5), une électrode de blindage basse tension (11) et une électrode de blindage haute tension (10), dans lequel l'électrode haute tension comprend un matériau conducteur et l'électrode basse tension comprend un matériau conducteur ;
dans lequel le diviseur de tension résistif comprend une première résistance (3) et une seconde résistance (5), dans lequel la première résistance comprend une première extrémité et une seconde extrémité opposée à la première extrémité et la seconde résistance comprend une première extrémité et une seconde extrémité opposée à la première extrémité ;
dans lequel la seconde extrémité de la première résistance est connectée électriquement à la première extrémité de la seconde résistance, et la première résistance et la seconde résistance sont agencées suivant un axe du diviseur de tension résistif ;
dans lequel la première extrémité de la première résistance est connectée électriquement à la borne haute tension ;
dans lequel la seconde extrémité de la seconde résistance est connectée électriquement à la borne de potentiel de masse ;
dans lequel l'électrode haute tension présente une forme conique, dans lequel l'électrode haute tension est connectée électriquement directement à la borne haute tension, et dans lequel seulement une partie de la première résistance est localisée à l'intérieur de la forme conique de l'électrode haute tension ;
dans lequel l'ouverture de la forme conique de l'électrode haute tension fait face à distance à la borne haute tension, et dans lequel la forme conique de l'électrode haute tension présente un diamètre maximum au niveau de l'ouverture qui présente une section en coupe transversale circulaire ;
dans lequel un axe central qui passe par le centre de l'ouverture de la forme conique de l'électrode haute tension est coaxial à l'axe du diviseur de tension résistif ;
dans lequel l'électrode basse tension présente une forme conique, dans lequel l'électrode basse tension est connectée électriquement directement à la borne de potentiel de masse, et dans lequel la seconde résistance est localisée à l'intérieur de la forme conique de l'électrode basse tension ;
dans lequel l'ouverture de la forme conique de l'électrode basse tension fait face à distance à la borne de potentiel de masse, et dans lequel la forme conique de l'électrode basse tension présente un diamètre maximum au niveau de l'ouverture qui présente une section en coupe transversale circulaire ;
dans lequel un axe central qui passe par le centre de l'ouverture de la forme conique de l'électrode basse tension est coaxial à l'axe du diviseur de tension résistif ;
dans lequel l'électrode haute tension est espacée de l'électrode basse tension ; et
dans lequel le diamètre maximum de l'ouverture de la forme conique de l'électrode haute tension est inférieur au diamètre maximum de l'ouverture de la forme conique de l'électrode basse tension.

2. Agencement de moyenne ou haute tension selon la revendication 1, dans lequel une partie de l'électrode haute tension est localisée à l'intérieur de l'électrode basse tension.

3. Agencement de moyenne ou haute tension selon l'une quelconque des revendications 1 et 2, dans lequel l'extrémité de l'électrode haute tension au niveau de l'ouverture et l'extrémité de l'électrode basse tension au niveau de l'ouverture sont arrondies selon un rayon minimum de 0,1 mm.

4. Agencement de moyenne ou haute tension selon l'une quelconque des revendications 1 à 3, dans lequel le rapport de réactances capacitives de l'électrode haute tension sur l'électrode basse tension est égal à un rapport des valeurs de résistance de la première résistance sur la seconde résistance.
